# EUROPEAN PATENT APPLICATION

(11) **EP 0 993 035 A1**
(43) Date of publication of application: **12.04.2000**
(21) Application number: 99910804.6
(22) Date of filing: 01.04.1999
(51) Int. Cl.: H01L 21/66

(54) **PROBE DEVICE**

(30) Priority: 04.04.1998 JP 10858198
(71) Applicant: Tokyo Electron Limited, Tokyo 107-8481 (JP)
(72) Inventor: KUJI, Motohiro, B-202, Tanaka-Besuto, Nakakoma-gun, amanashi 409-3842 (JP); AKAIKE, Yutaka, Nishiyatsushiro-gun, Yamanashi 409-3612 (JP)
(74) Representative: HOFFMANN - EITLE
(86) International application number: JP9901726
(87) International publication number: WO9952139

(57) **Abstract**

A probe apparatus 10 comprises a probe card 13, a main chuck 12, an X-stage 14 and a Y-stage 15. A vertical drive mechanism 18 is provided such that an extension line from a center for inspection of the probe card 13 coincides with an axis of the vertical drive mechanism. A static-pressure thrust air bearing 19, which is coaxial with the vertical drive mechanism 18 and vertically drives a main chuck 12, is provided as a vertically movable member. A gap-maintaining means 23 is provided to maintain a gap at a constant size between the static thrust air bearing 19 and the main chuck 12.

## Description

### Technical Field

The present invention relates to a probe apparatus, and more particularly to a probe card with a plurality of probe terminals which are put in contact with a plurality of electrodes of an object to be tested, thereby to test electrical characteristics of the object.

### Background Art

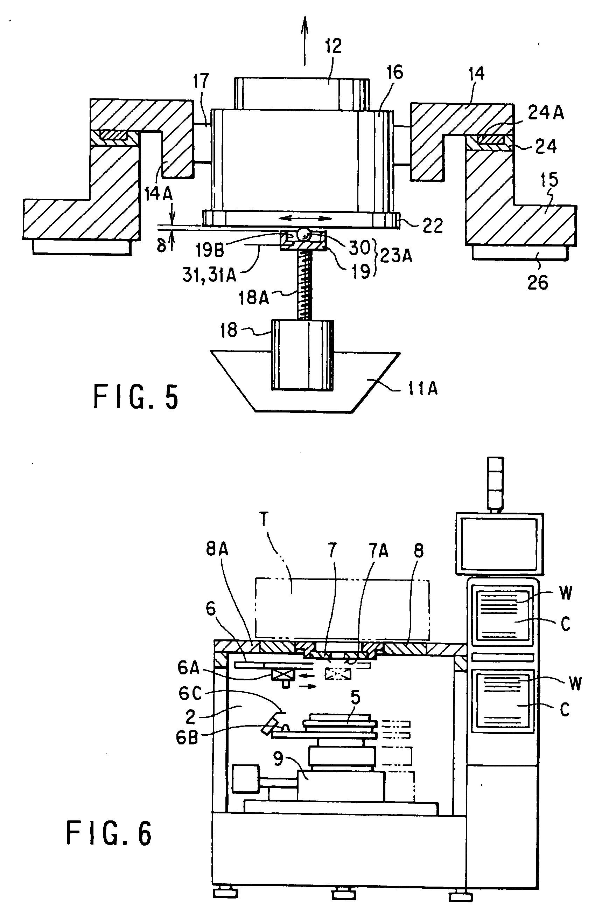

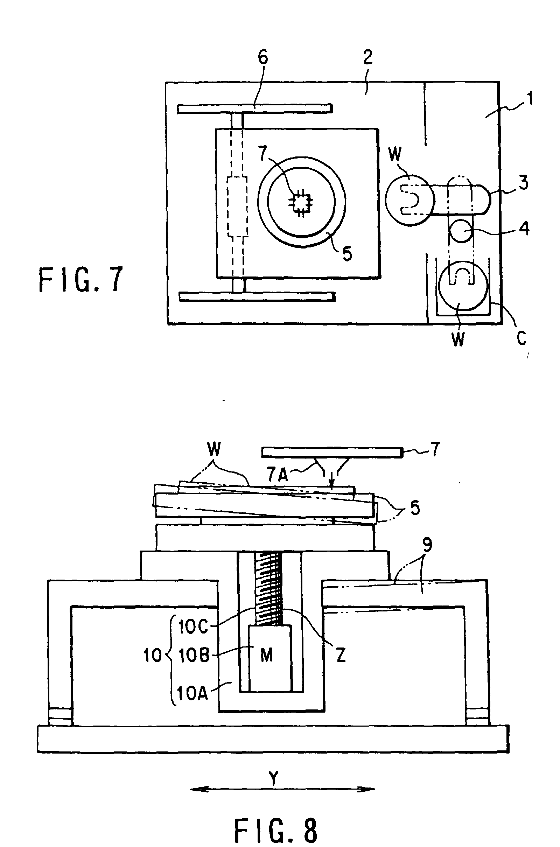

FIGS. 6 and 7 show a conventional probe apparatus for testing electrical characteristics of semiconductor devices formed on a semiconductor wafer. The probe apparatus comprises a loader chamber 1 for pre-aligning a wafer W and feeding the wafer W, and a prober chamber 2 for receiving the wafer W from the loader chamber 1 and testing the electrical characteristics thereof. A probe card 7 is detachably attached to a head plate 8 which forms a top surface of the prober chamber 2.

As is shown in FIG. 7, fork 3 and a sub-chuck 4 are provided in the loader chamber 1. While the wafer W is being carried by the fork 3, the wafer W is pre-aligned by the sub-chuck 4 with reference to its orientation flat.

A main chuck 5 and an alignment mechanism 6 having upper and lower cameras 6A and 6B are provided in the prober chamber 2. The main chuck 5, on which the wafer W is placed, cooperates with the alignment mechanism 6 while moving in X-, Y-, Z- and θ-directions, thereby aligning electrodes formed on the wafer W with probe terminals 7A of the probe card 7. Following the completion of alignment, the main chuck 5 rises to bring the electrodes on the wafer W placed on the main chuck 5 into electrical contact with the probe terminals 7A. A test head T connected to the probe terminals inspects electrical characteristics of the semiconductor devices formed on the wafer W. A temperature adjustment mechanism is built in the main chuck. The temperature adjustment mechanism sets the temperature of the wafer W within a wide range of, e.g. -50°C to +160°C. Thus, the wafer W can be tested at normal, low, or high temperatures.

When the electrical characteristics of the wafer W are to be inspected, the wafer W is placed on the main chuck 5, the temperature of which has been set at a predetermined value by the temperature adjustment mechanism. The main chuck and alignment mechanism 6 cooperate to align the electrode pads of semiconductor devices formed on the wafer W with the probe terminals 7A of the probe card. The main chuck 5 is raised to put the electrode pads of the semiconductor devices into electrical contact with the probe terminals 7A. The test head T connected to the probe terminals 7A inspects the electrical characteristics of the semiconductor devices.

As is shown in FIG. 6, the main chuck 5 is fixed to an XY-stage which is reciprocally movable in the X- and Y- directions (for convenience' sake, an X-stage and a Y-stage being described as a single structure). The main chuck 5 is reciprocally moved in the X- and Y-directions by the XY-stage 9.

A vertical drive mechanism 10 for moving the main chuck 5 in the Z-direction is fixed to the XY-stage 9, as schematically shown in FIG. 8. The vertical drive mechanism 10 comprises a motor 10B provided in, e.g. a cylindrical container 10A, a ball screw 10C rotated by the motor 10B, and a nut member (not shown) engaged with the ball screw. The main chuck 5 is elevated in the Z-direction in FIG. 8 by means of the nut member in accordance with the rotation of the ball screw 10C, so that the electrode pads of the semiconductor devices formed on the wafer W may be put in contact with the probe terminals 7A of the probe card. The distance, over which the main chuck 5 is elevated, is measured, for example, by using the upper and lower cameras 6A and 6B and a target 6C of alignment mechanism 6. Based on the measured data, the vertical drive mechanism 10 is driven.

Specifically, the probe terminals 7A, target 6C and wafer W are imaged by the upper and lower cameras 6A and 6B, and the distance of elevation is calculated on the basis of the positional coordinates data.

The current size of wafers is 6 inches or 8 inches. If the size of wafers is increased to 12 inches in the future, the patterns of integrated circuits will be made much finer and the pitch of electrode pads will further decrease. To cope with this, conventional probe apparatuses have to solve various problems. For example, if the number of chips to be measured at a time increases, the number of electrode pads of each chip also increases. Accordingly, the number of probe terminals 7A increases and the weight of the probe card increases up to, e.g. several kg. When chips located on a peripheral portion of the wafer are to be tested, part of the weight acts unevenly on a peripheral portion of the wafer (action due to offset load). Due to this action, the main chuck 5 is inclined as indicated by a dot-and-dash line in FIG. 8 in an exaggerated fashion. As a result, the XY-stage 9 deforms and there arises a variance in contact pressure (needle pressure) between respective probe terminals 7A and wafer W. The reliability of inspection may thus deteriorate.

Furthermore, if the wafer size increases to, e.g. 12 inches, the distance between the center of the main chuck and the point of contact of the probe increases and accordingly the inclination of the main chuck 5 due to offset load increases. The variance in contact pressure of probe terminals 7A further increases and in worse cases some of the probe terminals 7A do not come in contact with the wafer W.

### Disclosure of Invention

The present invention aims at solving the above problems.

Specifically, the invention aims at always keeping, even it objects to be inspected increase in diameter in the future, the mounting table horizontal in inspections and always putting the contact terminals and the object in contact under uniform pressure, thereby enhancing the reliability of the inspection.

The invention also aims at smoothly moving the mount table in the horizontal and vertical directions and controlling the vertical movement of the mount table very easily.

The applicant previously proposed an invention relating to the present apparatus in Japanese Patent KOKAI Application No. 11-26524. The previously proposed invention is improved in the present invention, and a probe apparatus wherein the vertical movement of the mounting table can be easily controlled is proposed.

According to a first aspect of the present invention, there is provided a probe apparatus comprising:
a probe card with a plurality of probe terminals, the probe card being disposed on an upper surface of an inside of a prober chamber for inspecting electrical characteristics of an object to be tested;
a mounting table, disposed below the probe card, for mounting of the object;
a drive mechanism for reciprocally driving the mounting table in one horizontal direction and another horizontal direction perpendicular to the one horizontal direction;
a vertical drive mechanism situated below the mounting table and having a vertical movement shaft, the vertical drive mechanism vertically driving the vertical movement shaft along a line extended downward from a center for an inspection of the probe card;
a vertically movable member, connected to a distal end portion of the vertical movement shaft, for supporting the mounting table and vertically moving the mounting table in accordance with vertical movement of the vertical movement shaft; and
a gap-maintaining mechanism for maintaining a gap between the vertically movable member and the mounting table.

It is preferable that the gap-maintaining mechanism have a static-pressure thrust gas bearing on the vertically movable member.

It is preferable that the gap-maintaining mechanism further include a magnetic action causing mechanism on the vertically movable member, the magnetic action causing mechanism functioning to attract the mounting table toward the vertically movable member.

It is preferable that the gap-maintaining mechanism comprise:
a static-pressure thrust gas bearing having at least one opening portion on an upper surface of the vertically movable member, and a mechanism for supplying compressed air to the opening portion; and
a magnetic action causing mechanism including at least one magnet on the upper surface of the vertically movable member.

It is preferable that the gap-maintaining mechanism include at least one spherical body rotatably provided between the vertically movable member and the mounting table.

It is preferable that the gap-maintaining mechanism further include a vacuum suction mechanism for drawing the mounting table toward the vertically movable member.

It is preferable that the gap-maintaining mechanism further include a magnetic action causing mechanism provided on the vertically movable member, the magnetic action causing mechanism functioning to attract the mounting table toward the vertically movable member.

It is preferable that the mechanism for reciprocally driving the mounting table comprise:
a first stage capable of vertically guiding the mounting table and reciprocally driving the same in a first horizontal direction; and
a second stage capable of supporting the first stage such that the first stage is reciprocally movable in the first horizontal direction, and capable of reciprocally moving in a horizontal direction perpendicular to the first horizontal direction.

### Brief Description of Drawings

The accompanying drawings, which are incorporated in and constitute a part of the specification, illustrate presently preferred embodiments of the invention, and together with the general description given above and the detailed description of the preferred embodiments given below, serve to explain the principles of the invention.
FIG. 1 is a plan view showing an embodiment of a prober chamber of a probe apparatus according to the present invention.
FIG. 2 is a cross-sectional view showing a main part of the prober chamber shown in FIG. 1.
FIGS. 3A and 3B are perspective views showing examples of a static-pressure thrust air bearing provided in the prober chamber shown in FIG. 2.
FIG. 4 is a graph showing a relationship between a gap defined by the static-pressure thrust air bearing of the probe apparatus shown in FIG. 2 and the load on the Z-stage.
FIG. 5 is a cross-sectional view showing another embodiment of the probe apparatus according to the present invention.
FIG. 6 is a front view of a conventional probe apparatus, with a front side of the prober chamber being cut away.
FIG. 7 is a plan view of the probe apparatus shown in FIG. 6.
FIG. 8 is a cross-sectional view schematically showing the main chuck of the probe apparatus shown in FIG. 6.

### Best Mode of Carrying Out the Invention

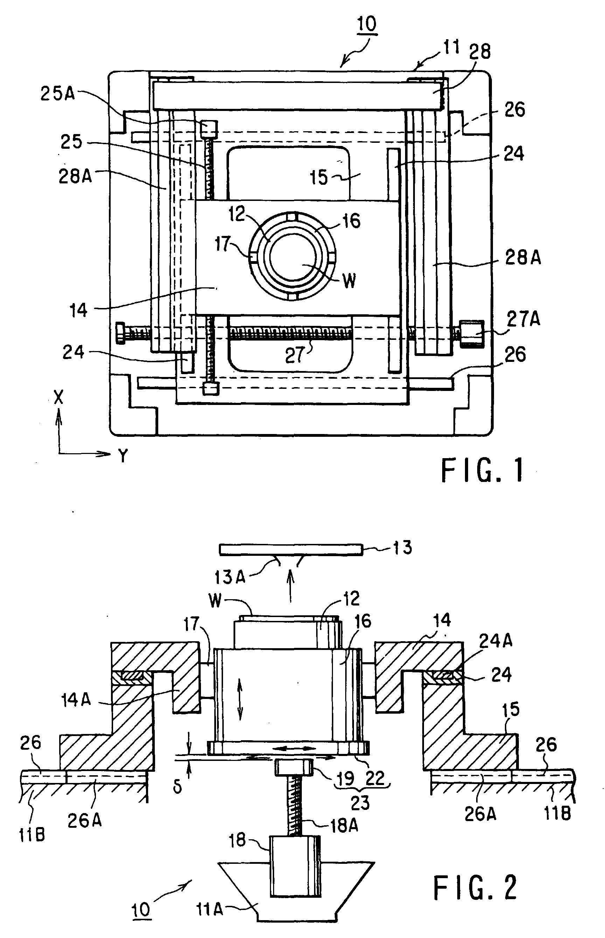

The present invention will now be described on the basis of embodiments shown in FIGS. 1 to 5. A probe apparatus 10 of the embodiment, as shown in FIGS. 1 and 2, is characterized by a vertical drive mechanism of a main chuck within a prober chamber 11. Specifically, a main chuck 12, on which a wafer W of, e.g. 12 inches is placed, is provided within the prober chamber 11 of the embodiment. A probe card 13 is fixed above the main chuck 12. The main chuck 12, as shown in FIGS. 1 and 2, is reciprocally moved in X- and Y-directions by a first stage (X-stage) 14 and a second stage (Y-stage) 15 and is vertically moved in an Z-direction by a Z-stage 16. Thereby, the wafer W placed on the main chuck 12 is put in electric contact with probe terminals 13A of the probe card 13. In this contact state, the electrical characteristics of the wafer W are inspected.

The drive mechanisms for the X-, Y- and Z-stages 14, 15 and 16 will now be described in detail.

A cylindrical guide 14A extending vertically downward is provided at a central portion of the X-stage. The Z-stage 16 for supporting the main chuck 12 is disposed inside the cylindrical guide 14A. A plurality of axially extending LM guides 17 are provided on an inner paripheral surface of the cylindrical guide 14A at regular intervals in the circumferential direction. When the Z-stage 16 is vertically moved in the Z-direction, the LM guides 17 guide the Z-stage 16. A vertical drive mechanism 18 is fixed below the Z-stage 16 within the prober chamber 11. A vertically movable member 19 is fixed to a top end of a drive shaft (e.g. ball screw) 18A of the vertical drive mechanism 18. The vertically movable member 19 vertically drives the Z-stage 16 in accordance with vertical movement of the drive shaft 18A.

The center of the vertically movable member 19 and an inspection center of the probe card 13 (i.e. a center of a plurality of probe terminals) are situated on an extension line of the axis of the ball screw 18A. This positional relationship remains unchanged even if the main chuck moves in the X- and Y-directions for inspection. In FIG. 2, numeral 11A denotes a static plane (stationary plane) within the prober chamber 11.

In this embodiment, as shown in FIG. 2, a small gap δ is defined between a bottom plate 22 provided at the lower part of the main chuck 16 and the vertically movable member 19. With this gap δ maintained, the Z-stage 16 can smoothly be moved in the X-, Y- and Z-directions with respect to the vertically movable member 19.

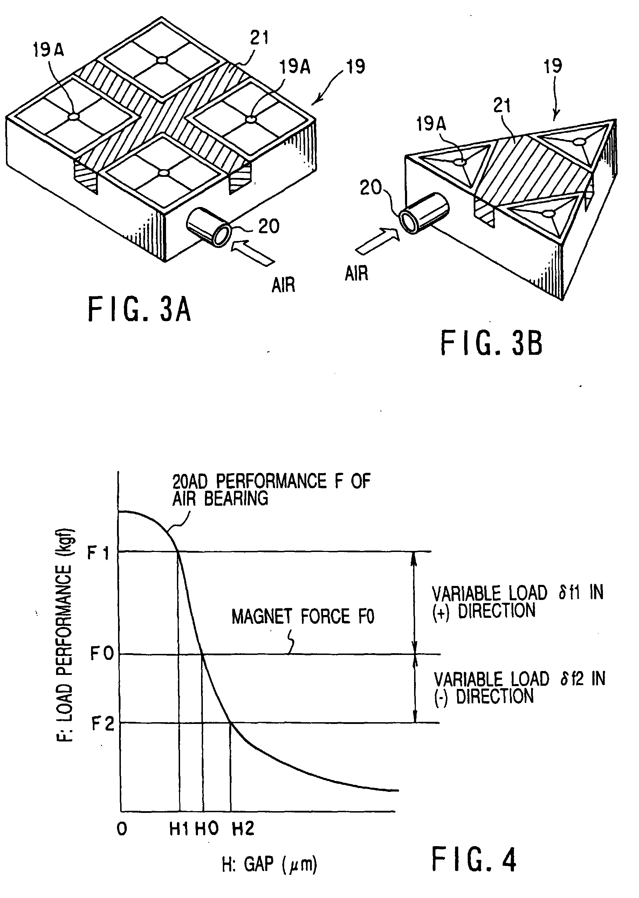

This gap δ is maintained by a gap maintaining mechanism. An example of the gap maintaining mechanism will now be described with reference to FIG. 3A. Opening portions 19A are formed at a plurality of locations on one side surface of the vertically movable member 19, as shown in FIG. 3A. An internal passage (not shown) connected to the opening portions 19A is formed in the vertically movable member 19. An air pipe 20 is connected to the opening portions 19A of the internal passage provided on the side surface. During inspections, compressed air is always supplied to the internal passage via the air pipe 20 and the compressed air is jetted from the opening portions 19A. The Z-stage 16 is lifted over the vertically movable member 19 by the pressure of the jetted air. The vertically movable member 19 functions as a static-pressure thrust air bearing having a square plane. During inspections, the Z-stage is moved in the X- and Y-directions over the vertically movable member 19 in an air slide method.

The probe apparatus according to this embodiment, as described above, is characterized by the structure in which the Z-stage is not held by the vertically movable member (static-pressure thrust air bearing) 19. This structure may be improved.

In this probe apparatus, even after the vertical drive mechanism ceases to rise, the Z-stage 16 further rises due to inertia force so that more than a predetermined gap may be present between the Z-stage 16 and static-pressure thrust air bearing 19 (excessive rising). Owing to the excessive rising, the semiconductor wafer placed on the main chuck is brought into contact with the probe terminals 13A under high pressure, and the probe terminals 13A may be damaged. It is preferable that the probe apparatus described according to this embodiment be provided with an excessive rising prevention mechanism for preventing the Z-stage 16 from rising due to inertia force. A magnetic action causing mechanism utilizing a magnetic action may be adopted as an example of the excessive rising prevention mechanism. The magnetic action causing mechanism utilizes a magnetic action of a magnet (e.g. permanent magnet), thereby attracting the Z-stage 16 toward the static-pressure thrust air bearing 19 and maintaining the gap between the Z-stage 16 and vertically movable member 19 at a constant value δ. A permanent magnet 21 may be disposed at peripheral areas of the opening portions 19A formed on the static-pressure thrust air bearing 19. In the vertically movable member 19 shown in FIG. 3A, the opening portions 19A are formed at the corners of the surface of the vertically movable member 19 and the permanent magnet is disposed in a cross-shaped groove formed among the opening portions 19A. The bottom plate 22 of magnetic material, which is attached to the bottom surface of the Z-stage 16, is attracted toward the vertically movable member 19 by the magnetic action of the permanent magnet 21. Thus, the static-pressure thrust air bearing 19, permanent magnet 21 and bottom plate 22 constitute gap maintaining means comprising the excessive rising prevention mechanism for maintaining the gap δ between the static-pressure thrust air bearing 19 and bottom plate 22 at a substantially constant value. The lift of the static-pressure thrust air bearing 19 and the attractive force of the permanent magnet 21 may be properly set according to the structure of the probe apparatus 10.

FIG. 4 shows a relationship between a load performance and the gap δ between the static-pressure thrust air bearing 19 and Z-stage 16. In FIG. 4, the load performance (ordinate) indicates, in its positive (+) direction, a load on the X-stage 16 in the direction of gravity. An intersection between a curve representing a load performance F of the air bearing and a line drawn from point F0 indicates that the value of gap δ is maintained at H0 (abscissa) because of balance between the magnet force at load performance F0 and the lift force of the static-pressure thrust air bearing 19. In this state, a varying load is zero. According to FIG. 4, if a load δ f1 acts on the Z-stage 16 due to excessive rising at the time of inspection, the gap δ decreases from H0 to H1. On the other hand, if an inertia force δf2 acts on the Z-stage 16 when the vertical drive mechanism 18 stops and the Z-stage 16 ceases to vertically move, the gap δ increases from H0 to H2.

Accordingly, if the gap maintaining mechanism comprises only the static-pressure thrust air bearing 19, the gap the gap δ varies in a range exceeding H2 at the time of inspection and the distance of vertical movement of the Z-stage 16 cannot exactly be controlled. In this embodiment, as described above, the excessive rising prevention mechanism comprising the permanent magnet 21 and bottom plate (magnetic body) 22 applies magnet force to the X-stage 16 so as to keep substantially constant the gap δ between the static-pressure thrust air bearing 19 and bottom plate 22 (in the range between H1 and H2 in FIG. 4). The gap δ should preferably be limited to the range of, e.g. 10 µm.

The X-stage 14 reciprocally moves in the X-direction on the Y-stage 15. As is shown in FIG. 2, LM guides 24 are provided as an example of a pair of guide rails (hereinafter referred to as "X-guide rails") on the Y-stage 15. Engaging members 24A (see FIG. 2) are provided on the lower surface of the X-stage 14. The engaging members 24A are engaged with the X-guide rails 24. As is shown in FIG. 1, an X-directional ball screw (hereinafter referred to as "X-ball screw") 25 is provided on the Y-stage 15 near the inner side of the left-side X-guide rail 24. The X-ball screw 25 is engaged with a nut member (not shown) attached to the lower surface of the X-stage 14. The X-ball screw 25 is rotated in forward and reverse directions to reciprocally move the X-stage 14 on the Y-stage 15 in the X-direction.

The Y-stage 15 is provided on a base frame 11B of the prober chamber 11 and is reciprocally moved on the base frame 11B in the Y-direction. Specifically, a pair of guide rails (hereinafter referred to as "Y-guide rails") 26 extending the Y-direction are provided at both end portions in the X-direction on the base frame 11B. Engaging members 26A are attached to both end portions in the X-direction of the Y-stage 15. These Y-guide rails 26 are engaged with the engaging members 26A. In addition, a Y-directional ball screw (hereinafter referred to as "Y-ball screw") 27 is provided on the base frame 11B near the inner side of the Y-guide rail 26 (see the lower part of FIG. 1). The Y-ball screw 27 is rotated in forward and reverse directions by a motor 27A. The Y-ball screw 27 is engaged with a nut member (not shown) attached to the lower surface of the Y-stage 15. The Y-ball screw 27 is rotated forwardly and reversely to reciprocally move the Y-stage 15 on the base frame 11B in the Y-direction.

An alignment bridge 28 of an alignment mechanism is provided in the prober chamber 11 so as to be movable along the paired guide rails 28A provided in the Y-direction. An upper camera (not shown) attached to the alignment bridge 28 images the wafer W on the main chuck 12. A lower camera (not shown) attached to the main chuck 12 images the probe terminals 13A of probe card 13. On the basis of the image data, the probe terminals 13A and inspection electrode pads (not shown) formed on the wafer W are aligned. A mechanism proposed in Japanese Patent Application No. 10-054423 can be used as the alignment mechanism.

The operation of the probe apparatus according to the present invention will now be described.

If the probe apparatus 10 is driven, the Z-stage 16 is lifted by the vertical drive mechanism 18 along the cylindrical guide 14A of X-stage 14, while a predetermined gap is maintained between the Z-stage 16 and static-pressure thrust air bearing 19 by the gap maintaining means 23 comprising the static-pressure thrust air bearing 19, permanent magnet 21 and bottom plate (magnetic body) 22. Then a pre-aligned wafer W is loaded from the loader chamber (not shown) onto the main chuck 12 within the prober chamber 11. With the alignment mechanism in operation, the Z-stage 16 is moved in the X- and Y-directions by the X- and Y-stages 14 and 15 while a gap is maintained between the Z-stage 16 and static-pressure air bearing 19. In addition, the Z-stage 16 is rotated forwardly and reversely in the θ-direction. Thus, the wafer W on the main chuck 12 is aligned with the probe terminals 13A of probe card 13. When the aligned wafer W is to be inspected, the Z-stage 16 is moved in the X- and Y-directions by the X- and Y-stages 14 and 15 with the gap maintained. The wafer W on the main chuck 12 is brought to, and halted at, the initial position for inspection.

Following the above, the vertical drive mechanism 18 is operated, and the Z-stage 16 is raised by the static-pressure air bearing 19 in the state in which the Z-stage 16 is out of contact with the static-pressure thrust air bearing 19. Accordingly, the electrode pads for inspection of wafer W on the main chuck 12 are put in contact with the probe terminals 13A of probe card 13. The vertical drive mechanism 18 halts after overdriving the Z-stage 16. At this time, the attractive force due to the magnetic action between the permanent magnet 21 and bottom plate 22 prevents the Z-stage 16 from rising excessively due to inertia force and maintains the gap δ stably. As a result, the inspection electrode pads can be put in contact with the probe terminals 13A under stabilized pressure.

The inspection position at the initial stage is on the peripheral portion of the wafer W. Consequently, in the prior art, the needle pressure of the probe terminals 13A acts on the peripheral portion of the main chuck 12 in a biased manner. As a result, the main chuck is inclined, as shown in FIG. 8. In the embodiment of the present invention, the vertically moving member (static-pressure thrust air bearing) 19, which is always positioned just below the inspection center of the probe card 13, receives the needle pressure of the probe terminals 13A. Thus, the needle pressure does not act on the peripheral portion of the main chuck 12 in a biased manner and the main chuck 12 is always supported horizontal. Accordingly, the probe terminals 13A are put in contact with the wafer W under uniform pressure during the inspection, and the reliable inspection is always stably performed.

Although the gap δ between the Z-stage and vertically movable member varies from H0 to H1, the gap in the range of H1 is maintained. Thus, the probe terminals 13A can be put in contact with the inspection electrode pads under a predetermined needle pressure. Subsequently, the wafer W is moved by index-feeding and the above inspection is repeated. The gap maintaining means 23 operates throughout the inspection to maintain the gap δ in the range between H1 and H2.

As has been described above, according to the present embodiment, a downward extension line from the inspection center of the probe card 13 always coincides with the axis of the vertically movable member (static-pressure thrust air bearing) 19 of the vertical movement mechanism 18 for main chuck 12. Accordingly, the needle pressure of the probe terminals 13A is always received by the static-pressure thrust air bearing 19 situated immediately thereunder, and the load due to the needle pressure of the probe terminals 13A is prevented from acting on the main chuck 12 in a biased manner. The mounting surface of the main chuck 12 is always kept horizontal and the probe terminals 13A are exactly put in contact with the wafer W under uniform pressure at all times. Therefore, the reliability of inspection is enhanced.

Air with a predetermined pressure is fed to the static-pressure thrust air bearing 19, whereby the gap-maintaining means 23 comprising the static-pressure thrust air bearing 19, permanent magnet 21 and bottom plate (magnetic body) 22 can maintain the gap δ between the Z-stage 16 and static-pressure thrust air bearing 19 at a substantially fixed size. The main chuck 12 can smoothly moved in the horizontal direction, and the distance of vertical movement of the main chuck 12 can be controlled exactly and easily.

FIG. 5 shows a main part of another embodiment of the probe apparatus according to the present invention. The probe apparatus 10A of this embodiment has the same structure as the preceding embodiment except for the gap-maintaining means. The same or similar structural elements as with the preceding embodiment are denoted by like reference numerals in the following description. Gap-maintaining means 23A in the present embodiment, as shown in FIG. 5, comprises a spherical member 30, provided on the vertically movable member 19, for defining a gap δ between the Z-stage 16 and vertically movable member 19, and vacuum suction means 31 for sucking the Z-stage 16 toward the vertically movable member 19. The vacuum suction means 31 is always operated during inspections. The vertically movable member 19 is formed in a cap shape, and a recess 19B is formed in an upper surface thereof. For example, one spherical member 30 is rotatably mounted at the center of the recess 19B. An internal passage (not shown) is formed in the vertically movable member 19. The internal passage communicates with at least one opening formed at the recess 19B and also communicates with an opening formed at a side surface of the vertically movable member 19. A vacuum pipe 31A is connected to the opening at the side surface of the vertically movable member 19, and the inside of the recess 19B is evacuated by an evacuation device (not shown). The Z-stage 16 is vacuum-suctioned and prevented from excessively rising.

It is preferable that the gap δ between the Z-stage 16 and vertically movable member 19 be set at, e.g. 10 µm or less. If the gap exceeds 10 µm, the suction force of the vacuum suction means 31 for sucking the Z-stage 16 sharply decreases and the Z-stage 16 may not be prevented from rising excessively. The suction force of the vacuum suction means 31 can be properly set according to the structure, etc. of the probe apparatus 10.

In the present embodiment, if the probe apparatus 10 is driven, the vacuum suction means 31 of the gap-maintaining means 23A is operated and, with the gap δ provided between the vertically movable member 19 and Z-stage 16, the Z-stage 16 is drawn toward the vertically movable member 19 by vacuum force. During the inspection, when the Z-stage 16 is overdriven and the vertically movable mechanism 18 stops, the excessive rising of the Z-stage 16 due to inertia force is prevented since the vacuum suction force of the vacuum suction means 31 is acting on the Z-stage 16. In addition, the same advantageous effects as with the preceding embodiment can be expected.

According to the invention of claims 1 to 4, even if objects to be inspected increase in diameter in the future, the mounting table is always kept horizontal in inspections and the contact terminals and the object are always put in contact under uniform pressure. Therefore, the reliability of the inspection is enhanced. Moreover, there is provided the probe apparatus wherein the mount table can be smoothly moved in the horizontal and vertical directions and the vertical movement of the mount table can be controlled very easily.

The present invention is not limited to the above-described embodiments.

The present invention covers all probe apparatuses wherein the downward extension line from the center of inspection of the probe card coincides with the axes of the vertical drive mechanism and vertically movable member provided within the prober chamber and inspections are performed in the state in which a predetermined gap is maintained by the gap-maintaining means between the mount table and the vertically movable member.

For example, in the above embodiments, the vertically movable member 19, bottom plate 22, Z-stage 16 and main chuck 12 have cylindrical shapes. However, these members may have other shapes.

In FIG. 3A, the opening portions 19A are provided at four locations on the upper surface of the vertically movable member. The number of opening portions 19A, however, may be at least one. Accordingly, two, three, five or more opening portions may be provided.

In addition, in FIG. 3A, the permanent magnet 21 has a cross-shape. However, the permanent magnet 21 may have another shape in consideration of the arrangement of the opening portions 19A.

Although the permanent magnet is used as the magnetic action causing mechanism in FIG. 3A, an electromagnet may be substituted.

Other features and modifications of the invention are conceivable by a person skilled in the art. Therefore, the present invention is based on a broader standpoint and should not be limited to specific and typical embodiments described here in detail. Accordingly, various modifications may be made in the invention without departing from the broad concept of the invention defined in the attached claims and the scope of interpretation of equivalents of the defined invention.

## Claims

1. A probe apparatus comprising:
a probe card with a plurality of probe terminals, the probe card being disposed on an upper surface of an inside of a prober chamber for inspecting electrical characteristics of an object to be tested;
a mounting table, disposed below the probe card, for mounting of the object;
a drive mechanism for reciprocally driving the mounting table in one horizontal direction and another horizontal direction perpendicular to said one horizontal direction;
a vertical drive mechanism situated below the mounting table and having a vertical movement shaft, the vertical drive mechanism vertically driving the vertical movement shaft along a line extended downward from a center for an inspection of the probe card;
a vertically movable member, connected to a distal end portion of the vertical movement shaft, for supporting the mounting table and vertically moving the mounting table in accordance with vertical movement of the vertical movement shaft; and
a gap-maintaining mechanism for maintaining a gap between the vertically movable member and the mounting table.

2. The probe apparatus according to claim 1, wherein said gap-maintaining mechanism has an air bearing mechanism on the vertically movable member.

3. The probe apparatus according to claim 2, wherein said air bearing mechanism is a static-pressure thrust gas bearing.

4. The probe apparatus according to claim 3, wherein said gap-maintaining mechanism further includes a magnetic action causing mechanism on said vertically movable member, the magnetic action causing mechanism functioning to attract the mounting table toward the vertically movable member.

5. The probe apparatus according to claim 4, wherein said gap-maintaining mechanism comprises:
a static-pressure thrust gas bearing having at least one opening portion on an upper surface of the vertically movable member, and a mechanism for supplying compressed air to the opening portion; and
a magnetic action causing mechanism including at least one magnet on the upper surface of the vertically movable member.

6. The probe apparatus according to claim 1, wherein said gap-maintaining mechanism includes at least one spherical body rotatably provided between the vertically movable member and the mounting table.

7. The probe apparatus according to claim 6, wherein said gap-maintaining mechanism further includes a vacuum suction mechanism for drawing the mounting table toward the vertically movable member.

8. The probe apparatus according to claim 6 or 7, wherein said gap-maintaining mechanism further includes a magnetic action causing mechanism provided on the vertically movable member, the magnetic action causing mechanism functioning to attract the mounting table toward the vertically movable member.

9. The probe apparatus according to claim 1, wherein said mechanism for reciprocally driving the mounting table comprises:
a first stage capable of vertically guiding the mounting table and reciprocally driving the same in a first horizontal direction; and
a second stage capable of supporting the first stage such that the first stage is reciprocally movable in said first horizontal direction, and capable of reciprocally moving the first stage in a horizontal direction perpendicular to said first horizontal direction.
